**Europäisches Patentamt**

**European Patent Office**

**Office européen des brevets**

(19)

(11) Veröffentlichungsnummer: **0 078 481**
**B1**

(12) **EUROPÄISCHE PATENTSCHRIFT**

(45) Veröffentlichungstag der Patentschrift:
**14.08.85**

(51) Int. Cl.⁴: **H 01 R 9/09**

(21) Anmeldenummer: **82109848.0**

(22) Anmeldetag: **25.10.82**

(54) Kontaktierungsvorrichtung mit einem Klemmelement zum Kontaktieren von elektrischen Kontaktstellen auf Leiterplatten.

(30) Priorität: **30.10.81 DE 3143174**

(43) Veröffentlichungstag der Anmeldung:
**11.05.83 Patentblatt 83/19**

(45) Bekanntmachung des Hinweises auf die Patenterteilung:
**14.08.85 Patentblatt 85/33**

(84) Benannte Vertragsstaaten:
**AT BE CH FR GB IT LI NL SE**

(56) Entgegenhaltungen:
**FR - A - 2 290 127**
**FR - A - 2 365 932**
**FR - A - 2 459 559**
**US - A - 3 551 750**

(73) Patentinhaber: **Siemens Aktiengesellschaft, Berlin und München Wittelsbacherplatz 2, D-8000 München 2 (DE)**

(72) Erfinder: **Patscheck, Max, Konrad-Celtis-Strasse 65, D-8000 München 70 (DE)**
Erfinder: **Veh, Günther, Zugspitzstrasse 4, D-8931 Hiltenfingen (DE)**

## Beschreibung

Die Erfindung betrifft eine Kontaktierungsvorrichtung mit einem Klemmelement zum Kontaktieren von elektrischen Kontaktstellen auf Leiterplatten mit einer in der zugehörigen Aufnahmevorrichtung für Leiterplatten vorgesehenen Stromschiene.

Elektrische Baugruppen wie z. B. Funktionseinheiten von Platters (gedruckte Schaltungen für die Aufnahme von Modulplatten) müssen in den zugehörigen Gehäusen so befestigt werden, dass eine gute Kontaktierung der Leiterplattenrandzonen zu den Stromschienen, an denen sie befestigt werden, gewährleistet ist. Dabei ist zu beachten, dass in die Baugruppen Ströme von ca. 300 bis 400 A bei Spannungen von etwa 5 V fliessen und die Spannungsabfälle sehr klein gehalten werden sollen.

Aufgabe der Erfindung ist es daher, elektronische Baugruppen in Aufnahmevorrichtungen so zu befestigen, dass ein guter Kontakt zwischen den Leiterplattenrandzonen mit den Stromschienen der Aufnahmevorrichtung erfolgt, wobei die Montage zeitsparend erfolgen soll.

Zur Lösung dieser Aufgabe ist die Kontaktierungsvorrichtung gemäss der Erfindung gekennzeichnet durch eine aus einem zylindrischen Rohrsegment bestehende Klemmschiene, die entlang ihrer Längsachse in vorgegebenem Abstand mit Formlochungen versehen ist, durch die sie über Schrauben an den Stromschienen derart befestigbar ist, dass die Kanten der Klemmschienen an den Kontaktstellen zweier über- oder nebeneinanderliegender Leiterplatten oder einer Leiterplatte und einer Stromschiene anliegen sowie durch Reiter, die zwischen der Klemmschiene und den Schraubenköpfen der Schrauben liegen und die an ihrer Unterseite eine dem Aussenradius der Klemmschiene angepasste zylindrische Hohlfläche und auf ihrer Oberseite eine Planfläche aufweisen.

Durch diese Massnahmen erhält man eine rasch montierbare Kontaktierungsvorrichtung mit guter elektrischer Kontaktierung, wobei unabhängig von der Winkelstellung der Klemmschienen die Befestigungsschrauben ihre gerade Form beibehalten. Auch nach mehrmaligem Austauschen der elektronischen Baugruppen ist die Kontaktqualität sehr gut, was sich in niedrigen Spannungsabfällen auswirkt.

Anhand der Ausführungsbeispiele nach den Fig. 1 bis 3 wird die Erfindung näher erläutert.

Fig. 1 zeigt eine perspektivische Darstellung einer Aufnahmevorrichtung, in die eine Plattereinheit eingesetzt und mit Hilfe einer Kontaktierungsvorrichtung nach der Erfindung mit den Stromschienen kontaktiert ist,

Fig. 2 eine Einzelheit in der Nähe der Schraubbefestigung der Klemmschiene in einem ersten Ausführungsbeispiel,

Fig. 3 eine Einzelheit in der Nähe der Schraubbefestigung für die Klemmschiene, bei der zwei Leiterplatten miteinander und mit der zugehörigen Stromschiene kontaktiert werden.

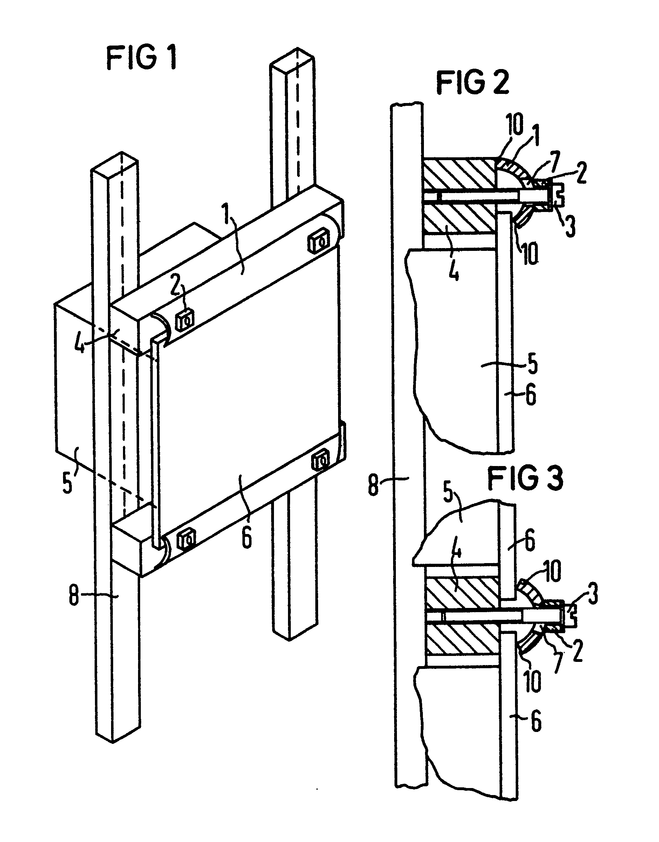

In Fig. 1 ist ein Ausschnitt aus einer Aufnahmevorrichtung, wie sie beispielsweise bei EDV-Anlagen verwendet wird, gezeigt. Quer zu den Längsschienen 8 sind die Stromschienen 4 angeordnet, die in der Regel aus Aluminium bestehen. Eine Plattereinheit, bestehend aus dem Platter 6 und dem Gehäuse 5, in dem sich die an der Platterleiterplatte angeschlossenen Flachbaugruppen befinden, wird zwischen den Stromschienen eingebracht und mit diesen verbunden. Die Randzonen der Platterleiterplatte 6 sind dabei elektrisch leitend ausgebildet. Die Verbindung zwischen den Randzonen des Platters 6 und den Stromschienen 4 wird über eine Klemmschiene 1 vorgenommen, die aus einem Rohrsegment besteht. Dieses Rohrsegment wird mit Schrauben an den Stromschienen 4 befestigt.

Einzelheiten dieser Schraubbefestigung sind aus der Fig. 2 zu entnehmen, die eine Querschnittsdarstellung in der Nähe der Schraubbefestigung zeigt. Die Klemmschiene 1 wird dabei auf die Stromschiene 4 und die leitende Zone des Platters 6 geklemmt und mit einer Schraube 3, die durch das Formloch 7 der Klemmschiene hindurchgesteckt wird, an der Stromschiene 4 mit Hilfe einer Gewindebohrung befestigt. Zwischen dem Schraubenkopf der Schraube 3 und der Klemmschiene 1 ist ein Reiter 2 angebracht, der an seiner Unterseite entsprechend dem Aussenradius der Klemmschiene eine hohlzylindrische Fläche aufweist, während er an der Oberseite mit einer Planfläche versehen ist.

Durch diese Konstruktion wird die Schraube immer in waagerechter Richtung gehalten, unabhängig davon, in welcher Winkelstellung sich die Klemmschiene gerade befindet. Durch das Anziehen der Schraube werden die Kanten 10 der Klemmschiene auf die Stromschiene 4 und die Kontaktzonen des Platters aufgedrückt und ergeben dadurch eine gute elektrische Verbindung und einen kleinen Übergangswiderstand.

In Fig. 3 ist eine Einzelheit in der Nähe der Schraubbefestigung gezeigt, wobei hier zwei Leiterplatten mit ihren kontaktierten Randzonen über die Klemmschiene 1 miteinander verbunden werden. Im übrigen unterscheidet sich diese Ausführung nicht von der nach Fig. 2. Auch hier wird durch den Reiter zwischen der Schraube 3 und der Klemmschiene 1 erreicht, dass ein Kippen und Verwinden der Schraube verhindert wird.

## Patentanspruch

Kontaktierungsvorrichtung mit einem Klemmelement (1) zum Kontaktieren von elektrischen Kontakstellen auf Leiterplatten (6) mit einer in der zugehörigen Aufnahmevorrichtung für Leiterplatten vorgesehenen Stromschiene (4), gekennzeichnet durch eine aus einem zylindrischen Rohrsegment bestehende Klemmschiene (1), die entlang ihrer Längsachse in vorgegebenem Abstand mit Formlochungen (7) versehen ist, durch die sie über Schrauben (3) an den Stromschienen (4) derart befestigbar ist, dass die Kanten (10) der Klemmschiene (1) an den Kontaktstellen zweier über- oder nebeneinanderliegender Leiterplatten (6) oder einer Leiterplatte (6) und einer Stromschiene (4) anliegen sowie durch Reiter (2), die zwischen der Klemmschiene (1) und den Schraubenköpfen der Schrauben (3) liegen und die an ihrer Unterseite eine dem Aussenradius der Klemmschiene (1) angepasste zylindrische Hohlfläche und auf ihrer Oberseite eine Planfläche aufweisen.

## Claim

A contacting device having a clamping element (1) for contacting of electric contact positions on circuit boards (6), and a bus bar (4) which is provided in the associated device for accommodating circuit boards, characterized by a clamping rail (1) which consists of a cylindrical tube segment and which is provided along its longitudinal axis at predetermined intervals with shaped openings (7) by means of which it can be attached by screws (3) to the bus bar (4) in such a way that the edges (10) of the clamping rail (1) contact the contact positions of two circuit boards (6) arranged one above another, or one beside another, or of one circuit board (6) and one bus bar (4), and further by sliding contacts (2) which are arranged between the clamping rail (1) and the screw heads of the screws (3) and which on their underside have a hollow cylindrical surface which is matched to the outer radius of the clamping rail (1) and on their upper side have a flat surface.

## Revendication

Dispositif de réalisation de contacts comprenant un élément de serrage (1) pour assurer le contact en des points électriques de contact sur des plaquettes de circuits imprimés (6) et d'un rail de conducteur (4) prévu dans le dispositif associé de réception des plaquettes de circuits imprimés, caractérisé par un rail de serrage (1) constitué d'un segment de tube cylindrique, qui est muni le long de son axe longitudinal, à des intervalles donnés à l'avance, de perforations conformées (7) par lesquelles il peut être fixé par des vis (3) au rail conducteur (4) de manière que les bords (10) du rail de serrage (1) portent contre les emplacements de contact de deux plaquettes de circuits imprimés (6) disposées l'une au-dessus de l'autre ou l'une à côté de l'autre ou contre une plaque de circuits imprimés (6) et un rail conducteur (4), ainsi que par des cavaliers (2) qui se trouvent entre le rail de serrage (1) et les têtes de vis (3) et qui présentent, sur leur côté inférieur, une surface cylindrique concave adaptée au rayon extérieur du rail de serrage et, sur leur côté supérieur, une surface plane.

FIG 1

FIG 2

FIG 3